Europäisches Patentamt

European Patent Office

Office européen des brevets

(19)

(11) Veröffentlichungsnummer : **0 029 490**
**B1**

(12) **EUROPÄISCHE PATENTSCHRIFT**

(45) Veröffentlichungstag der Patentschrift :
**29.02.84**

(21) Anmeldenummer : **80105579.9**

(22) Anmeldetag : **17.09.80**

(51) Int. Cl.³ : **H 03 K 13/24**, H 03 K 13/01,
H 04 L   3/00

(54) **Verfahren zur Umwandlung von linear codierten digitalen Signalen in nicht linear codierte digitale Signale gemäss einer dem A-Gesetz oder dem My-Gesetz gehorchenden Mehrfachsegmentkennlinie.**

(30) Priorität : **26.09.79 DE 2938984**

(43) Veröffentlichungstag der Anmeldung :
**03.06.81 Patentblatt 81/22**

(45) Bekanntmachung des Hinweises auf die Patenterteilung : **29.02.84 Patentblatt 84/09**

(84) Benannte Vertragsstaaten :
**FR GB SE**

(56) Entgegenhaltungen :
**DE-A- 2 824 254**
**US-A- 3 863 248**
**US-A- 4 037 226**
**Patents Abstracts of Japan, Band 3, Nr. 66, 7. Juni 1979 Seite 153E115**

(73) Patentinhaber : **SIEMENS AKTIENGESELLSCHAFT
Berlin und München Wittelsbacherplatz 2
D-8000 München 2 (DE)**

(72) Erfinder : **Zeiträg, Rolf, Dipl.-Ing.
Dompfaffweg 3
D-8000 München 82 (DE)**

Verfahren zur Umwandlung von linear codierten digitalen Signalen in nicht linear codierte digitale Signale gemäß einer dem A-Gesetz oder dem μ-Gesetz gehorchenden Mehrfachsegmentkennlinie

Die Erfindung betrifft ein Verfahren zur Umwandlung von linear codierten digitalen Signalen in nicht linear codierte digitale Signale gemäß einer dem A-Gesetz oder dem μ-Gesetz gehorchenden Mehrfachsegmentkennlinie durch Zuordnung der in den beiden Codierungsarten codierten Signalwerte unter Zuhilfenahme von mehr als einem Zuordnungsspeicher.

Wenn durch periodische Abtastung gewonnene Abtastproben analoger Signale in Digital-Signale in Form von PCM-Worten umgewandelt werden, erfolgt eine Zuordnung der aus einem unbegrenzten Wertevorrat sich zusammensetzenden Analogwerte wegen der begrenzten Anzahl von verwendeten Codierungselementen zu einer begrenzten Anzahl von Amplitudenstufen. Es findet also eine sogenannte Quantisierung statt. Als Folge einer solchen Quantisierung ergibt sich ein Quantisierungsrauschen. Um zu gewährleisten, daß dieses Quantisierungsrauschen nicht als Störung empfunden wird, muß ein bestimmtes Verhältnis von Analogsignalamplitude zu der quantisierungsbedingten Störamplitude eingehalten sein.

Bei Verwendung von 4 000 Amplitudenstufen, die gleichmässig über den gesamten Amplitudenbereich der Analog-Signale verteilt sind, würde man zwar ein ausreichendes Nutz-Stör-Verhältnis erreichen. Es müssten dann allerdings Digital-Signale übertragen werden, die wenigstens zwölf Codezeichenelemente aufweisen. Außerdem wäre bei einer solchen gleichmäßigen Stufenverteilung im Bereich der großen Analogwertamplituden der Störabstand überflüssig hoch. Im Zuge der Codierung wird daher eine Kompandierung vorgenommen, d. h. eine Umwandlung von linearer Codedarstellung in nichtlineare Codedarstellung derart, daß das Nutz-Stör-Verhältnis über den gesamten Amplitudenbereich konstant ist. Ein genau konstantes Signal-Stör-Verhältnis ergibt sich mit einer logarithmischen Kompandierungskennlinie. In der Praxis wird mit entsprechend einfacher zu realisierenden Kompandierungskennlinien gearbeitet, die dem sogenannten A-Gesetz oder dem sogenannten μ-Gesetz gehorchen. Bei Anwendung des A-Gesetzes wird gemäß einer Kennlinie gearbeitet, die aus dreizehn geradlinigen Segmenten zusammengesetzt ist, beim μ-Gesetz sind es fünfzehn Segmente. Die Steigung der Geraden dieser Kennlinien nimmt in jeder der beiden Halbebenen von Segment zu Segment um den Faktor 2 ab. Jedes Segment wiederum ist in sechzehn gleich große Quantisierungsfächer unterteilt, deren Höhe jeweils um den Faktor 2 von Segment zu Segment anwächst. Diese Gesetzmäßigkeit ist im ersten Segment unterbrochen. Bei Zugrundelegung des A-Gesetzes enthält das erste Segment 32 positive und 32 negative Quantisierungsfächer, die jeweils zwei Werte der linear kodierten Informationen umfassen. Beim μ-Gesetz ist das erste Segment in fünfzehn positive und fünfzehn negative Quantisierungsfächer, die ebenfalls zwei Werte linear kodierter Signale umfassen sowie in jeweils ein positives und ein negatives Quantisierungsfach unterteilt, das nur einen Wert des linear kodierten Signals umfaßt. Damit stehen beim A-Gesetz 8192 Schritten in linearer Codedarstellung 256 Schritte in kompandierter Darstellung gegenüber. Beim μ-Gesetz beträgt das Verhältnis von linear codierten Schritten zu nicht linear codierten Schritten 16318 zu 256.

Wenn man die erwähnte Zuordnung von linear codierten Signalwerten zu nicht linear codierten Signalwerten mit Hilfe eines Speichers vornimmt, dann sind bei Zugrundelegung des A-Gesetzes $2^{13}$ und bei Zugrundelegung des μ-Gesetzes $2^{14}$ Adressen notwendig, um die 256 möglichen nichtlinear codierten Signalwerte anzusteuern. Das bedeutet wegen der acht Bits, die zur nichtlinearen Codedarstellung erforderlich sind, eine Speicherkapazität im einen Falle von $2^{16}$ und im anderen Falle von $2^{17}$ Bits oder mit anderen Worten 64 k bit bzw. 128 k Bit. Verwendet man serienmäßige integrierte Halbleiterspeicher passender Größe, von denen hier solche mit 512 Speicherplätzen zu jeweils acht Bits also einer Speicherkapazität von 4 k Bit in Frage kommen, so benötigt man sechzehn bzw. 32 solcher Speicher, die jeweils zwanzig Anschlüsse haben. Gerade diese große Anzahl der insgesamt vorhandenen Anschlüsse ist aber in der Praxis besonders unerwünscht.

Eine Verringerung von Speicherkapazität und Anschlußzahl läßt sich dadurch erreichen, daß wie eingangs vorausgesetzt, mehr als ein Zuordnungsspeicher verwendet wird. Bei einer bekannten Anordnung dieser Art (JP-Patent 54-44861) sind drei solcher Zuordnungsspeicher verwendet, von denen der zweite und dritte Speicher alternativ wirksam sind, wobei deren Ausgänge miteinander verbunden sind. Eine derartige Anordnung erfodet, daß entweder eine Entkopplung der miteinander verbundenen Ausgänge vorgesehen ist, oder daß diese Ausgänge schaltungstechnisch derart ausgebildet sind, daß die im Ruhezustand von ihnen gelieferten Ausgangspotentiale von den dem Binärwert Null entsprechenden Ausgangssignalen unterschieden werden können (Tristate-Ausgänge).

Bei einer weiteren bekannten Anordnung zur Umwandlung linear codierter digitaler Signale in nicht linear codierter digitale Signale (US-Patent 3 863 248) wird zu Verringerung des Speicheraufwands so vorgegangen, daß eine erste Codewandlung von einem m Bits umfassenden linear codierten Codewort in ein p Bits umfassendes Codewort durch Verschiebe- und Zählprozeduren unter Verwendung eines Schieberegisters und eines Zählers vorgenommen wird, und daß erst das auf diese Weise p Bits umfassende Codewort einem Zuordnungsspeicher zugeführt wird, um in einer zweiten Codewandlung ein m Bits umfassendes nicht linear codiertes Codewort zu erzeugen. Gegenüber der Verwendung von ausschließlich Zuordnungsspeichern hat diese Anordnung den Nachteil des größeren Zeitaufwands bei der Codewandlung durch Verschieben der umzuwandelnden Bitkombinationen in dem genannten Schieberegister.

Die Aufgabe der vorliegenden Erfindung besteht nun darin, ein Verfahren der eingangs genannten Art dahingehend zu verbessern, daß bezüglich der Ausgänge der Zuordnungsspeicher die genannten Voraussetzungen entfallen können und daß darüber hinaus die Anzahl der Zuordnungsspeicher und damit auch die Anzahl der insgesamt vorhandenen Anschlüsse verringert werden kann.

Erfindungsgemäß wird diese Aufgabe mit einem Verfahren der eingangs genannten Art dadurch gelöst, daß zwei Zuordnungsspeicher verwendet sind, von denen dem ersten jeweils wenigstens so viele auf das höchstwertige, das Vorzeichen bestimmende Bit folgende höherwertige Bits eines linear codierten Signalwertes als Ansteueradresse zugeführt werden, wie zur Kennzeichnung des Segments der Kennlinie und der Lage der Stufengrenzen in dem Segment, in das der betreffende Signalwert fällt, erforderlich sind, wobei in den Speicherzellen dieses ersten Speichers Digitalwörter gespeichert sind, deren drei höchstwertige Bits die auf das Vorzeichen-Bit folgenden höchstwertigen Bits des entsprechenden nichtlinear codierten Signalwertes sind, die das Segment der Kennlinie angeben, auf der dieser Signalwert liegt, und deren übrige Bits eine höherwertige Teiladresse zur Ansteuerung des zweiten Speichers darstellen, dem als niedrigerwertiger Ansteueradressenteil die verbleibenden Bits, außer dem niedrigstwertigen Bit, das bei der Umwandlung unberücksichtigt bleibt, des jeweiligen linear codierten Signalwertes zugeführt werden, wobei in den Speicherzellen dieses zweiten Speichers die Bitkombinationen gespeichert sind, die die entsprechenden Stufen der Segmente der Kennlinie kennzeichnen, denen die nichtlinear codierten Signalwerte zugeordnet sind, und daß zur Bildung der nichtlinear codierten Signalwerte das höchstwertige Bit der linear codierten Signalwerte; die aus dem ersten Speicher ausgelesenen erwähnten drei höchstwertigen Bits als in der Wertigkeit nachfolgende Bits und die aus dem zweiten Speicher ausgelesenen Bitkombinationen als niedrigstwertige Bits herangezogen werden.

Nachstehend wird die Erfindung anhand eines Ausführungsbeispiels unter Bezugnahme auf zwei Figuren näher erläutert. In den Figuren zeigen :

Figur 1 die Gegenüberstellung einer Codetabelle linear codierter Signalwerte und einer Codetabelle zugeordneter nichtlinear codierter Signalwerte.

Figur 2 in schematischer Darstellungsweise die Anordnung zweier Speicher mit deren Ansteuer- und Ausgabeleitungen, wie sie zur Durchführung des erfindungsgemäßen Verfahrens eingesetzt werden.

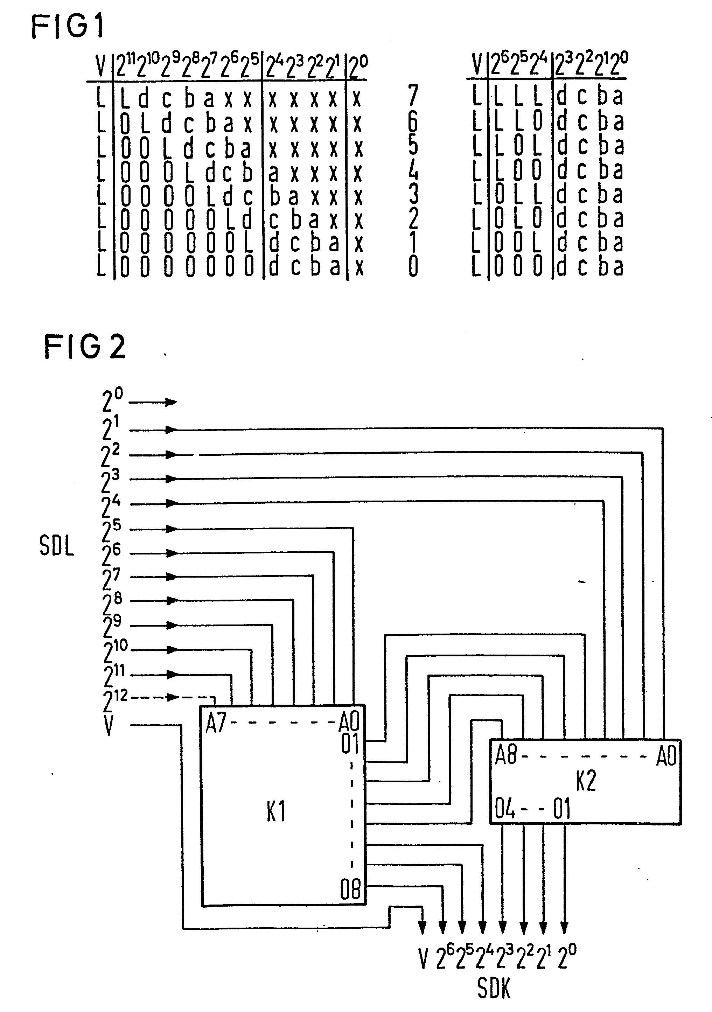

Die Figur 1 zeigt, wie angedeutet, eine Gegenüberstellung unter Verwendung von dreizehn Bits linear codierter digitaler Signale und der entsprechenden unter Verwendung von acht Bits nichtlinear codierter digitaler Signale, wobei der dargestellte Zusammenhang dem vorerwähnten A-Gesetz gehorcht. Es sind dabei lediglich die Verhältnisse in der positiven Hälfte der zugrunde gelegten Dreizehn-Segment-Kennlinie dargestellt ist. Für die negative Kennlinienhälfte gilt dieselbe Darstellung mit dem einzigen Unterschied, daß das höchstwertige Bit $2^{13}$ bei der linearen Darstellung bzw. $2^7$ bei der nichtlinearen Darstellung anstelle des Binärwertes L den Binärwert O aufweist. Die zwischen den beiden Codewortgruppen eingetragenen Zahlen 0 bis 7 geben an, daß die entsprechenden Zeilen die Segmente 0 bis 7 der Kennlinienhälfte betreffen, wobei darauf hingewiesen sei, daß die Segmente 0 und 1 beider Kennlinienhälften jeweils dieselbe Steigung aufweisen, sodaß die vollständige Kennlinie tatsächlich aus dreizehn Geraden zusammengesetzt ist.

Wie die nichtlineare Codedarstellung im rechten Teil der Figur zeigt, sind sämtliche der Segmente 0 bis 7 in sechzehn gleichgroße Stufen unterteilt, entsprechend den sechzehn möglichen unterschiedlichen Kombinationen a, b, c, d der vier niedrigstwertigen Bits $2^0$ bis $2^3$. Die drei nach dem höchstwertigen Bit $2^7$, das das Vorzeichen angibt, niedrigerwertigen Bits $2^6$ bis $2^4$ nehmen vom Segment 0 bis zum Segment 7 die Kombinationen OOO bis LLL an und stellen damit die segmentadresse dar.

Aus der Gegenüberstellung der beiden Arten von Codedarstellungen und insbesondere derjenigen, die das Segment O betreffen, sieht man, daß der Binärwert des niedrigstwertigen Bits $2^0$ der linearen Codedarstellung ohne Einfluß auf die Zuordnung zu einem nichtlinear dargestellten Codewort ist, d. h. also, daß eine Stufe bei der nichtlinearen Codedarstellung wenigstens zwei linear codierte Signalwerte umfaßt. Gemäß einem Teilmerkmal der Erfindung wird daher dieses niedrigstwertige Bit bei der Umwandlung von der einen Art der Codedarstellung in die andere unberücksichtigt gelassen. Der Vergleich der beiden Codetabellen zeigt darüber hinaus, daß im Segment 0 und im Segment 1 entsprechend den möglichen Bitkombinationen a, b, c, d jeweils 16 · 2 Linearschritte jeweils 16 Schritte in der nichtlinearen Codedarstellung entsprechen. Sie zeigt ferner, daß vom Segment 2 bis zum Segment 7 ansteigend die Quantisierungsfächer jeweils um den Faktor 2 größer werden, also im Segment 2 den sechzehn nichtlinear codierten Codewerten jeweils vier linear codierte Codewerte gegenüberstehen, die sich in den Kombinationsmöglichkeiten der Bits $2^0$ und $2^1$ unterscheiden, im Segment 3 den sechzehn nichtlinear codierten Codewerten jeweils acht linear codierte Codewerte gegenüberstehen, die sich durch die Kombinationsmöglichkeiten der Bits $2^0$ bis $2^2$ unterscheiden usw. usw. im Segment 7 den sechzehn nichtlinear dargestellten Codewerten jeweils 128 linear codierte Codewerte entsprechend den Kombinationsmöglichkeiten der Bits $2^0$ bis $2^6$ gegenüberstehen.

Die in Figur 2 dargestellte Anordnung zur Durchführung des erfindungsgemäßen Verfahrens weist zwei Speicher K1 und K2 auf, bei denen es sich um Festwertspeicher (ROM) oder um programmierbare Festwertspeicher (PROM) handelt.

Von den umzuwandelnden linear codierten Signalen SDL, die, sofern das µ-Gesetz zugrunde gelegt ist, unter Verwendung von vierzehn Bits $2^0$ bis $2^{12}$ und V und unter Zugrundelegung des A-Gesetzes durch dreizehn Bit $2^0$ bis $2^{11}$ und V gebildet sind, werden soviele auf das das Vorzeichen bestimmende höchstwertige Bit V folgende höherwertige Bits als Ansteueradresse zugeführt, wie zur Kennzeichnung des Segments der Kennlinie erforderlich sind, in die der betreffende Signalwert fällt. Bei Zugrundelegung des A-Gesetzes, auf das bei der weiteren Erläuterung Bezug genommen wird, sind dies, wie die der Lineardarstellung dienende Codetabelle in Figur 1 zeigt, die Bits $2^{11}$ bis $2^5$, da nur unter Einbeziehung all dieser Bits festgestellt werden kann, welche Lage die in den einzelnen Segmenten die Stufengrenzen angebenden Bits a, b, c, d einnehmen, die, abgesehen von den Segmenten 0 und 1, von Segment zu Segment anderswertige Bits $2^1$ bis $2^{10}$ umfassen.

Für die Umwandlung nach dem A-Gesetz weist der erste Festwertspeicher K1 demnach $2^7 = 128$ Speicherzellen auf. Im Falle einer Umwandlung nach dem µ-Gesetz sind es $2^8 = 256$ Speicherzellen.

In diesen Speicherzellen sind in entsprechender Zuordnung Digitalwörter gespeichert, deren drei höchstwertige Bits die auf das Vorzeichenbit folgenden höchstwertigen Bits des entsprechenden nichtlinear codierten Informationswertes sind, die, wie vorstehend erläutert, das Segment der Kennlinie angeben auf der dieser Informationswert liegt. Die übrigen Bits der erwähnten Digitalwörter, hier fünf, bilden eine Teiladresse zur Ansteuerung des zweiten Speichers K2. Die erwähnten Speicherzellen des ersten programmierbaren Speichers bieten daher Speicherplatz für jeweils acht Bits, so daß das gesamte Speichervolumen bei Zugrundelegung des A-Gesetzes 1 024 Bits beträgt.

Die aus dem ersten programmierbaren Speicher K1 auslesbare Teiladresse für den zweiten programmierbaren Speicher K2 stellt den höherwertigen Teil dessen Ansteueradressen dar. Als niedrigerwertiger Teil dessen Ansteueradressen dienen die verbleibenden Bits, außer dem niedrigstwertigen Bit der linear codierten Signale, hier also die Bits $2^1$ bis $2^4$.

Mit diesen neun Bits umfassenden Ansteueradressen können die 512 Speicherzellen des zweiten programmierbaren Speichers K2 angesteuert werden. In diesen Speicherzellen sind Bitkombinationen gespeichert, die die entsprechenden Stufen der Segmente der Kennlinie kennzeichnen, denen die einzelnen nichtlinear codierten Signalwerte zugeordnet sind. Entsprechend den obigen Ausführungen im Zusammenhang mit der Figur 1 umfassen diese Bitkombinationen vier Bits, woraus sich ein Speichervolumen des zweiten programmierbaren Speichers K2 von $512 \cdot 4 = 2\,048$ Bits ergibt.

Dem vorstehend erwähnten fall der Verwendung eines einzigen programmierbaren Speichers zur Umcodierung, der im Falle des A-Gesetzes eine Speicherkapazität von 64 k Bit aufzuweisen hätte, steht also bei der Anordnung zur Durchführung des erfindungsgemäßen Verfahrens ein Speicherplatzbedarf von nur 3 072 Bits gegenüber.

Wie die Figur 2 zeigt, werden zur Bildung der nichtlinear codierten digitalen Signale das Vorzeichenbit der linear codierten Signale direkt, als höchstwertiges Bit und damit Vorzeichenbit, die drei vorerwähnten aus dem ersten programmierbaren Speicher K1 auslesbaren Bits $2^6$ bis $2^4$ als Bits der nachfolgenden Wertigkeit und damit als die Segmentadresse darstellende Bits und schließlich die vier aus dem zweiten programmierbaren Speicher K2 auslesbaren Bits $2^3$ bis $2^0$ als niedrigstwertige Bits herangezogen. Das niedrigstwertige Bit $2^0$ der linear codierten digitalen Signale bleibt aus den oben erwähnten Gründen unberücksichtigt.

**Anspruch**

Verfahren zur Umwandlung von linear codierten digitalen Signalen in nichtlinear codierte digitale Signale gemäß einer dem A-Gesetz oder dem µ-Gesetz gehorchenden Mehrfachsegmentkennlinie durch Zuordnung der in den beiden Codierungsarten codierten Signalwerte unter Zuhilfenahme von mehr als einem Zuordnungsspeicher, dadurch gekennzeichnet, daß zwei solcher Speicher (K1, K2) verwendet werden, von denen dem ersten (K1) jeweils wenigstens soviele auf das höchstwertige, das Vorzeichen bestimmende Bit (V) folgende höherwertige Bits ($2^{12}$ bis $2^5$ für das µ-Gesetz bzw. $2^{11}$ bis $2^5$ für das A-Gesetz) eines linear codierten Signalwertes SDL als Ansteueradressen zugeführt werden, wie zur Kennzeichnung des Segments der Kennlinie und der Lage der Stufengrenzen in dem Segment, in das der betreffende Signalwert fällt, erforderlich sind, wobei in den Speicherzellen dieses ersten Speichers (K1) Digitalwörter gespeichert sind, deren drei höchstwertige Bits (08 bis 06) die auf das Vorzeichenbit (V) folgenden höchstwertigen Bits ($2^6$ bis $2^4$) des entsprechenden nichtlinear codierten Signalwertes (SDK) sind, die das Segment der Kennlinie angeben, auf der dieser Signalwert liegt und deren übrige Bits (05 bis 01) eine höherwertige Teiladresse (A8 bis A4) zur Ansteuerung des zweiten Speichers (K2) darstellen, dem als niedrigerwertiger Ansteueradressenteil (A3 bis A0) die verbleibenden Bits ($2^4$ bis $2^1$), außer dem niedrigstwertigen Bit ($2^0$), das bei der Umwandlung unberücksichtigt bleibt, des jeweiligen linear codierten Signalwertes (SDL) zugeführt werden, wobei in den Speicherzellen dieses zweiten Speichers (K2) die Bitkombinationen 04 bis 01 gespeichert sind, die die entsprechenden Stufen der Segment der Kennlinie kennzeichnen, denen die nichtlinear codierten Signalwerte (SDK) zugeordnet sind, und daß zur Bildung der nichtlinear codierten Signalwerte (SDK) das höchstwertige Bit (V) der linear codierten Signalwerte (SDL), die aus dem ersten Speicher (K1) ausgelesenen erwähnten drei höchstwertigen Bits (08 bis 06) als in der Wertigkeit nachfolgende Bits ($2^6$ bis $2^4$) und die aus dem zweiten Speicher (K2) ausgelesenen Bitkombinationen (04 bis 01) als niedrigstwertige Bits ($2^3$ bis $2^0$) herangezogen werden.

## Claim

Method for converting linearly coded digital signals into non-linearly coded digital signals in accordance with a multiple segment characteristic curve, which obeys the A-law or the μ-law, by allocating the signal values, which are coded in the two types of coding, with the aid of more than one allocation store, characterised in that two of such stores (K1, K2) are used, of which one (K1) is respectively fed with at least as many higher-order bits ($2^{12}$ to $2^5$ for the μ-law or $2^{11}$ to $2^5$ for the A-law) of a linearly coded signal value SDL, following the highest-order bit (V) which determines the preceding sign, as drive addresses are required for the identification of the segment of the characteristic curve and the position of the level limits in the segment, into which the respective signal value falls, where in the storage cells of this first store (K1) are stored digital words, whose three highest-order bits (08 to 06) are the highest-order bits ($2^6$ to $2^4$) of the corresponding non-linearly coded signal value (SDK), which follow the preceding sign bit (V) and which indicate the segment of the characteristic curve in which this signal value is arranged, and whose remaining bits (05 to 01) constitute a higher-order subaddress (A8 to A4) for driving the second store (K2), to which as low-order drive address section (A3 to A0), the remaining bits ($2^4$ to $2^1$), except the lowest-order bit ($2^0$) which remains neglected during the conversion, of the respective linearly coded signal value (SDL) are fed, where in the storage cells of this second store (K2), there are stored the bit combinations 04 to 01 which identify the corresponding levels of the segments of the characteristic curve which are assigned the non-linearly coded signal values (SDK), and that in order to form the non-linearly coded signal values (SDK) the highest-order bit (V) of the linearly coded values (SDL), said three highest-order bits (08 to 06) which have been read out from the first store (K1) as bits ($2^6$ to $2^4$) next following in significance, and the bit combinations (04 to 01), which have been read out from the second store (K2) as lowest-order bits ($2^3$ to $2^0$), are referred to.

## Revendication

Procédé pour convertir des signaux numériques codés linéairement en signaux numériques codés non linéairement selon une courbe caractéristique à segments multiples obéissant à la loi A ou à la loi mu, par association des valeurs de signaux codées dans les deux types de codage, moyennant l'utilisation de plus d'une mémoire de correspondances, caractérisé par le fait que l'on utilise deux mémoires (K1, K2) de ce type à la première desquelles on envoie en tant que signal de sélection au moins autant de bits de poids supérieur ($2^{12}$ à $2^5$ pour la loi mu ou $2^{11}$ à $2^5$ pour la loi A), succédant au bit (V) de poids maximum déterminant le signe, d'une valeur de signal codée linéairement (SDL) que cela est nécessaire pour caractériser le segment de la courbe caractéristique et de la position des limites d'échelons dans le segment, dans lequel se situe la valeur de signal considérée, que dans les cellules de mémoire de cette première mémoire (K1) sont mémorisés des mots numériques dont les trois bits de poids maximum (08 à 06) sont des bits ($2^6$ à $2^4$) de poids maximum, succédant au bit de signe (V), de la valeur de signal codée non linéairement correspondante (SDK), qui indiquent le segment de la courbe caractéristique dans laquelle se situe cette valeur de signal, et dont les autres bits (05 à 01) représentent une adresse partielle de poids supérieur (A8 à A4) servant à sélectionner la seconde mémoire (K2) à laquelle sont envoyés les bits restants ($2^4$ à $2^1$) hormis le bit de poids le plus faible ($2^0$), qui n'est pas pris en considération lors de la conversion, de la valeur de signal codée linéairement respective (SDL) et que dans les cellules de cette seconde mémoire (K2) sont mémorisées les combinaisons de bits 04 à 01 qui caractérisent les échelons correspondants des segments de la courbe caractéristique, auxquels sont associées les valeurs de signaux codés non linéairement (SDK), et que pour la formation des valeurs de signaux codées non linéairement (SDK), on utilise le bit de poids maximum (V) des valeurs de signaux codées linéairement (SDL), les trois bits de poids supérieur mentionnés (08 à 06) lus hors de la première mémoire, en tant que bits ($2^6$ à $2^4$) qui viennent à la suite du point de vue de la valence, et les combinaisons de bits (04 à 01) lues hors de la seconde mémoire (K2) en tant que bits possédant les poids les plus faibles ($2^3$ à $2^0$).

## FIG 1

| V | $2^{11}$ | $2^{10}$ | $2^9$ | $2^8$ | $2^7$ | $2^6$ | $2^5$ | $2^4$ | $2^3$ | $2^2$ | $2^1$ | $2^0$ | |
|---|---|---|---|---|---|---|---|---|---|---|---|---|---|
| L | L | d | c | b | a | x | x | x | x | x | x | x | 7 |
| L | 0 | L | d | c | b | a | x | x | x | x | x | x | 6 |
| L | 0 | 0 | L | d | c | b | a | x | x | x | x | x | 5 |
| L | 0 | 0 | 0 | L | d | c | b | a | x | x | x | x | 4 |
| L | 0 | 0 | 0 | 0 | L | d | c | b | a | x | x | x | 3 |
| L | 0 | 0 | 0 | 0 | 0 | L | d | c | b | a | x | x | 2 |
| L | 0 | 0 | 0 | 0 | 0 | 0 | L | d | c | b | a | x | 1 |
| L | 0 | 0 | 0 | 0 | 0 | 0 | 0 | d | c | b | a | x | 0 |

| V | $2^6$ | $2^5$ | $2^4$ | $2^3$ | $2^2$ | $2^1$ | $2^0$ |
|---|---|---|---|---|---|---|---|
| L | L | L | L | d | c | b | a |
| L | L | L | 0 | d | c | b | a |
| L | L | 0 | L | d | c | b | a |
| L | L | 0 | 0 | d | c | b | a |
| L | 0 | L | L | d | c | b | a |
| L | 0 | L | 0 | d | c | b | a |
| L | 0 | 0 | L | d | c | b | a |
| L | 0 | 0 | 0 | d | c | b | a |

## FIG 2

SDL

$2^0$, $2^1$, $2^2$, $2^3$, $2^4$, $2^5$, $2^6$, $2^7$, $2^8$, $2^9$, $2^{10}$, $2^{11}$, $2^{12}$, V

K1 — A7 … A0, 01 … 08

K2 — A8 … A0, 04 … 01

V $2^6$ $2^5$ $2^4$ $2^3$ $2^2$ $2^1$ $2^0$

SDK